# FASCICULE DE BREVET EUROPEEN

(11) **EP 4 445 434 B1**
(45) Date de publication et mention de la délivrance du brevet: **03.09.2025**
(21) Numéro de dépôt: 22821486.2
(22) Date de dépôt: 22.11.2022
(51) Int. Cl.: H10F 71/00

(54) **PROCÉDÉ DE FABRICATION D'UNE CELLULE PHOTOVOLTAÏQUE**
VERFAHREN ZUR HERSTELLUNG EINER FOTOVOLTAISCHEN ZELLE
METHOD FOR MANUFACTURING A PHOTOVOLTAIC CELL

(30) Priorité: 07.12.2021 FR 2113099
(43) Date de publication de la demande: 16.10.2024
(73) Titulaire: Commissariat à l'Energie Atomique et aux Energies Alternatives, 75015 Paris (FR); Ion Beam Services, 13790 Peynier (FR)
(72) Inventeur: LANTERNE, Adeline, 38054 Grenoble Cedex 09 (FR); DESRUES, Thibaut, 38054 Grenoble Cedex 09 (FR); LORFEUVRE, Coralie, 38054 Grenoble Cedex 09 (FR); TORREGROSA, Frank, 13109 Simiane Collongue (FR)
(74) Mandataire: INNOV-GROUP
(86) Numéro de dépôt international: PCT/EP2022/082870
(87) Numéro de publication internationale: WO 2023/104510

(56) Documents cités:
- FR-A1- 3 071 358
- US-A1- 2018 277 693

## Description

### Domaine technique

L'invention se rapporte au domaine technique des cellules photovoltaïques, en particulier des cellules photovoltaïques comportant un contact passivé sur chacune des surfaces du substrat. La passivation des surfaces est un enjeu majeur du secteur photovoltaïque, permettant de limiter les recombinaisons entre les porteurs minoritaires et majoritaires, et donc d'augmenter le nombre de porteurs collectés, ce qui se traduit par une amélioration significative de l'efficacité. Par « passivation », on entend la neutralisation de défauts électriquement actifs aux surfaces du substrat. En effet, une surface d'un substrat en silicium cristallin présente une densité de défauts (e.g. liaisons pendantes, impuretés, discontinuité du cristal etc.) pouvant entraîner des pertes non négligeables liées à la recombinaison en surface des porteurs dans le cas d'une application photovoltaïque.

Plus précisément, le contact passivé peut être une structure du type {oxyde/polysilicium}, comportant :
- un film d'oxyde, de préférence ultra mince (oxyde tunnel), tel qu'un oxyde de silicium, formé à la surface du substrat ;
- une couche de polysilicium, fortement dopée (de type n ou de type p), déposée sur le film d'oxyde.

Un tel contact passivé à base de polysilicium est une voie prometteuse par rapport à un contact passivé à base de silicium amorphe. En effet, un contact passivé du type {oxyde/polysilicium} forme une hétérojonction à haute température, pouvant supporter une température maximale de l'ordre de 1000 °C pour une cellule photovoltaïque en cours de fabrication, et une température maximale de l'ordre de 450°C pour une cellule photovoltaïque finalisée. A contrario, un contact passivé du type {oxyde/silicium amorphe} forme une hétérojonction à basse température, pouvant supporter une température maximale de l'ordre de 250°C. Ainsi, le fait de pouvoir travailler à une température supérieure à 250°C ouvre de plus larges possibilités pour passiver les bords de la cellule photovoltaïque après une découpe laser.

En outre, la couche de polysilicium du contact passivé du type {oxyde/polysilicium} possède des propriétés de piégeage d'impuretés (« *getter*» en langue anglaise), ce qui permet d'envisager l'utilisation de matériaux à faible empreinte de carbone.

Le fait que le polysilicium possède une conductivité électrique supérieure à celle du silicium amorphe permet d'élargir les spécifications relatives aux propriétés électriques de l'oxyde transparent conducteur déposé sur le polysilicium, ce qui facilite donc également l'utilisation d'un oxyde transparent conducteur sans indium.

L'invention trouve donc notamment son application dans la fabrication de cellules photovoltaïques de type silicium à hétérojonction à haute température (SHJ-HT).

### État de l'art

La couche de polysilicium du contact passivé présente l'inconvénient d'être absorbante dans les ultraviolets. Un compromis doit donc être recherché pour l'épaisseur de la couche de polysilicium afin d'assurer le rôle de contact électrique passivant la surface du substrat, sans affecter significativement le rendement de conversion de la cellule photovoltaïque. L'homme du métier recherche donc une épaisseur de polysilicium la plus fine possible afin de limiter les pertes par absorption. Plus précisément, l'homme du métier recherche une épaisseur la plus fine possible pour la couche de polysilicium dopée de type n, notée poly-Si (n+), en face avant de la cellule photovoltaïque destinée à être exposée à un rayonnement solaire, avec une bonne qualité de passivation.

Il existe deux méthodes principales pour former un contact passivé du type {oxyde/poly-Si (n+)} pour les cellules photovoltaïques de type SHJ-HT :
(i) dépôt d'une couche de silicium amorphe par un dépôt chimique à phase vapeur assisté par plasma (PECVD pour « *Plasma Enhanced Chemical Vapor Deposition* » en langue anglaise) avec une implantation des dopants, suivi d'un recuit pour cristalliser la couche de silicium amorphe et former une couche de polysilicium ; on parle de dopage in-situ ;
(ii) dépôt de la couche de polysilicium par un dépôt chimique en phase vapeur à basse pression (LPCVD pour « *Low Pressure Chemical Vapor Deposition* » en langue anglaise), suivi d'une diffusion de dopants, soit par voie gazeuse, soit par implantation des dopants ; on parle de dopage ex-situ.

La méthode (i) permet d'obtenir une couche de poly-Si (n+) selon une épaisseur supérieure à 20 nm avec une bonne qualité de passivation. En revanche, une couche de poly-Si (n+) présentant une épaisseur inférieure à 20 nm, obtenue par la méthode (i), conduit à une dégradation significative de la passivation.

La méthode (ii) permet d'obtenir une couche de poly-Si (n+) selon une épaisseur de 15 nm avec une bonne qualité de passivation. En revanche, une couche de poly-Si (n+) présentant une épaisseur strictement inférieure à 15 nm, obtenue par la méthode (ii), conduit à une dégradation significative des performances, pouvant être expliquée par une trop grande quantité de dopants introduits dans le substrat.

L'homme du métier recherche une solution pour obtenir une couche de poly-Si (n+) strictement inférieure à 15 nm tout en conservant une bonne qualité de passivation.

Une solution connue de l'état de la technique, notamment du document Y. Larianova et al., « Ultra-Thin Poly-Si Layers : Passivation Quality, Utilization of Charge Carriers Generated in the Poly-Si and Application on Screen-Printed Double-Side Contacted Polycrystalline Si on Oxide Cells », RRL Solar, vol. 4, n°10, 2020, consiste à :
- déposer une couche de polysilicium d'une épaisseur de 25 nm par LPCVD,
- introduire les dopants de type n dans la couche de polysilicium par implantation ionique,
- graver chimiquement la couche de polysilicium jusqu'à obtenir une épaisseur de polysilicium strictement inférieure à 15 nm.

La gravure chimique est contrôlée dans un bain de NH₄OH dilué. La température du bain doit être contrôlée précisément, ainsi que la concentration en NH₄OH et le temps d'immersion des plaques.

Une telle solution de l'état de la technique n'est donc pas entièrement satisfaisante en raison du contrôle contraignant devant être exercé sur le bain de NH₄OH dilué.

Le document FR 3 071 358 A1 décrit par ailleurs un procédé de fabrication d'une cellule photovoltaïque dans lequel une couche de silicium amorphe est cristallisée par recuit thermique, cette étape étant suivie d'une oxydation thermique qui permet la formation d'une couche d'oxyde, de sorte que cette couche d'oxyde consomme une certaine quantité de la couche de polysilicium précédemment obtenue.

### Exposé de l'invention

L'invention vise à remédier en tout ou partie aux inconvénients précités. A cet effet, l'invention a pour objet un procédé de fabrication d'une cellule photovoltaïque, comportant les étapes :
a) prévoir une structure comportant :
   - un substrat à base de silicium cristallin, présentant des première et seconde surfaces opposées ;
   - des premier et second films d'oxyde, de préférence de type oxyde tunnel, formés respectivement sur les première et seconde surfaces du substrat ;
   - des première et seconde couches de polysilicium, formées respectivement sur les premier et second films d'oxyde, et comprenant respectivement des dopants de type n et des dopants de type p présentant respectivement des première et seconde concentrations surfaciques ; les dopants de type n étant de préférence des atomes de phosphore, les dopants de type p étant de préférence des atomes de bore ; les première et seconde couches de polysilicium présentant chacune une épaisseur supérieure ou égale à 15 nm, de préférence supérieure ou égale à 20 nm ;
b) appliquer un recuit thermique à la structure, sous une atmosphère, à une température de recuit supérieure à une température minimale au-delà de laquelle les dopants de type n et les dopants de type p peuvent être électriquement activés ;
c) démarrer une injection d'un agent oxydant dans l'atmosphère au cours de l'étape b), de manière à former des première et seconde couches d'oxyde, respectivement sur les première et seconde couches de polysilicium ; l'injection étant démarrée à un premier instant définissant, avec la température de recuit, un premier budget thermique adapté pour activer électriquement les dopants de type n et les dopants de type p ;
d) arrêter l'injection de l'agent oxydant à un second instant définissant, avec la température de recuit, un second budget thermique adapté à la première concentration surfacique de sorte que :
   - les première et seconde couches d'oxyde, formées entre les premier et second instants, présentent respectivement des première et seconde épaisseurs ; la première épaisseur étant prédéterminée ;
   - la formation des première et seconde couches d'oxyde, selon les première et seconde épaisseurs, consomme une quantité de polysilicium entre les premier et second instants adaptée pour que la première couche de polysilicium présente une épaisseur strictement inférieure à 15 nm à l'issue de l'étape d).

Ainsi, un tel procédé selon l'invention permet d'obtenir une première couche de polysilicium, dopée de type n, notée poly-Si (n+), selon une épaisseur strictement inférieure à 15 nm à l'issue de l'étape d) sans nécessiter un bain de gravure chimique contrôlé en température comme dans l'état de la technique. En effet, la diminution de l'épaisseur de la couche de poly-Si (n+) s'effectue par une consommation de matière en raison de la réaction d'oxydation s'opérant entre les premier et second instants. Un tel procédé selon l'invention est donc beaucoup plus aisé à mettre en œuvre que celui de l'état de la technique.

Il est à noter que la seconde couche de polysilicium, dopée de type p, notée poly-Si (p+), est également consommée lors de la réaction d'oxydation s'opérant entre les premier et second instants. Toutefois, les inventeurs ont constaté expérimentalement que la réduction de l'épaisseur de la couche de poly-Si (p+) demeurait limitée par rapport à celle de la couche de poly-Si (n+) en raison de la différence notable entre les première et seconde concentrations surfaciques. Par ailleurs, l'épaisseur de la couche de poly-Si (p+) en face arrière est moins critique que l'épaisseur de la couche de poly-Si (n+) en termes d'absorption d'UV, puisque la seconde surface du substrat n'est pas destinée à être exposée à un rayonnement solaire direct.

Les inventeurs ont également constaté expérimentalement que l'injection de l'agent oxydant doit s'effectuer après l'activation électrique des dopants de type n et des dopants de type p. Si l'injection de l'agent oxydant démarre avant l'activation électrique des dopants de type n et des dopants de type p, les performances de la cellule en termes de passivation sont fortement dégradées, ce qui pourrait laisser penser à une destruction prématurée des dopants en surface de la couche de polysilicium correspondante sans avoir pu migrer en sites substitutionnels.

L'injection de l'agent oxydant est arrêtée au second instant défini lorsque l'épaisseur souhaitée de la première couche de polysilicium dopée de type n est obtenue.

L'invention a également pour objet un procédé de fabrication d'une cellule photovoltaïque, comportant les étapes :
a') prévoir une structure comportant :
   - un substrat à base de silicium cristallin, présentant des première et seconde surfaces opposées ;
   - des premier et second films d'oxyde, de préférence de type oxyde tunnel, formés respectivement sur les première et seconde surfaces du substrat ;
   - des première et seconde couches de silicium amorphe, formées respectivement sur les premier et second films d'oxyde, et comprenant respectivement des dopants de type n et des dopants de type p présentant respectivement des première et seconde concentrations surfaciques ; les dopants de type n étant de préférence des atomes de phosphore, les dopants de type p étant de préférence des atomes de bore ; les première et seconde couches de silicium amorphe présentant chacune une épaisseur supérieure ou égale à 15 nm, de préférence supérieure ou égale à 20 nm ;
b) appliquer un recuit thermique à la structure, sous une atmosphère, à une température de recuit supérieure à une température minimale au-delà de laquelle les première et seconde couches de silicium amorphe peuvent être cristallisées ;
c) démarrer une injection d'un agent oxydant dans l'atmosphère au cours de l'étape b), à un premier instant définissant, avec la température de recuit, un premier budget thermique adapté pour cristalliser les première et seconde couches de silicium amorphe de manière à former des première et seconde couches de polysilicium ; l'étape c) étant exécutée de manière à former des première et seconde couches d'oxyde, respectivement sur les première et seconde couches de polysilicium ;
d) arrêter l'injection de l'agent oxydant à un second instant définissant, avec la température de recuit, un second budget thermique adapté à la première concentration surfacique de sorte que :
   - les première et seconde couches d'oxyde, formées entre les premier et second instants, présentent respectivement des première et seconde épaisseurs ; la première épaisseur étant prédéterminée ;
   - la formation des première et seconde couches d'oxyde, selon les première et seconde épaisseurs, consomme une quantité de polysilicium entre les premier et second instants adaptée pour que la première couche de polysilicium présente une épaisseur strictement inférieure à **15** nm à l'issue de l'étape d).

Ainsi, un tel procédé selon l'invention permet d'obtenir une première couche de polysilicium, dopée de type n, notée poly-Si (n+), selon une épaisseur strictement inférieure à 15 nm à l'issue de l'étape d) sans nécessiter un bain de gravure chimique contrôlé en température comme dans l'état de la technique. En effet, la diminution de l'épaisseur de la couche de poly-Si (n+) s'effectue par une consommation de matière en raison de la réaction d'oxydation s'opérant entre les premier et second instants. Un tel procédé selon l'invention est donc beaucoup plus aisé à mettre en œuvre que celui de l'état de la technique.

Il est à noter que la seconde couche de polysilicium, dopée de type p, notée poly-Si (p+), est également consommée lors de la réaction d'oxydation s'opérant entre les premier et second instants. Toutefois, les inventeurs ont constaté expérimentalement que la réduction de l'épaisseur de la couche de poly-Si (p+) demeurait limitée par rapport à celle de la couche de poly-Si (n+) en raison de la différence notable entre les première et seconde concentrations surfaciques. Par ailleurs, l'épaisseur de la couche de poly-Si (p+) en face arrière est moins critique que l'épaisseur de la couche de poly-Si (n+) en termes d'absorption d'UV, puisque la seconde surface du substrat n'est pas destinée à être exposée à un rayonnement solaire direct.

Les inventeurs ont également constaté expérimentalement que l'injection de l'agent oxydant doit s'effectuer après l'activation électrique des dopants de type n et des dopants de type p (s'effectuant lors de la cristallisation des première et seconde couches de silicium amorphe). Si l'injection de l'agent oxydant démarre avant l'activation électrique des dopants de type n et des dopants de type p, les performances de la cellule en termes de passivation sont fortement dégradées, ce qui pourrait laisser penser à une destruction prématurée des dopants en surface de la couche de silicium amorphe correspondante sans avoir pu migrer en sites substitutionnels.

L'injection de l'agent oxydant est arrêtée au second instant défini lorsque l'épaisseur souhaitée de la première couche de polysilicium dopée de type n est obtenue.

Ce procédé selon l'invention diffère du précédent objet en ce que les dopants de type n et les dopants de type p sont incorporés préalablement dans une couche de silicium amorphe, qui est cristallisée lors du recuit thermique de l'étape b) de manière à former une couche de polysilicium. On parle alors de dopage in-situ.

Le procédé selon l'invention peut comporter une ou plusieurs des caractéristiques suivantes.

Selon une caractéristique de l'invention, le recuit thermique appliqué lors de l'étape b) comporte :
- une première phase, comprenant une montée en température jusqu'à atteindre la température de recuit ;
- une deuxième phase, comprenant un plateau de température égal à la température de recuit ;
- une troisième phase, comprenant une descente en température à partir de la température de recuit ;
procédé dans lequel l'étape c) est exécutée de sorte que l'injection de l'agent oxydant est démarrée durant la deuxième phase, et l'étape d) est exécutée de sorte que l'injection de l'agent oxydant est arrêtée durant la deuxième phase.

Ainsi, les inventeurs ont constaté expérimentalement que les premier et second instants étaient avantageusement choisis durant la deuxième phase (le premier instant étant choisi après l'activation électrique des dopants) afin d'obtenir une qualité satisfaisante de la passivation des surfaces du substrat. En effet, d'autres configurations n°1 à 3 (détaillées ci-dessous) conduisent à une dégradation importante de la passivation :
- configuration n°1 : le premier instant est choisi durant la première phase, et le second instant est choisi durant la deuxième phase ;
- configuration n°2: le premier instant est choisi durant la deuxième phase (avant l'activation électrique des dopants), et le second instant est choisi durant la deuxième phase ;
- configuration n°3 : les premier et second instants sont choisis durant la troisième phase.

Selon une caractéristique de l'invention, l'étape c) est exécutée de sorte que l'agent oxydant comporte du dioxygène O₂.

Ainsi, un avantage procuré est la facilité d'injection de ce gaz dans un four.

Selon une caractéristique de l'invention, l'atmosphère sous laquelle est appliqué le recuit thermique lors de l'étape b) comporte du diazote N₂ ou de l'argon Ar.

Selon une caractéristique de l'invention, l'étape d) est exécutée de sorte que les première et seconde épaisseurs sont supérieures ou égales à 2 nm.

Ainsi, un avantage procuré par de telles épaisseurs est d'autoriser une consommation de matière du polysilicium.

Selon une caractéristique de l'invention, le procédé comporte une étape e) consistant à retirer les première et seconde couches d'oxyde formées entre les premier et second instants ; l'étape e) étant exécutée après l'étape d), de préférence par une solution d'acide fluorhydrique HF.

Selon une caractéristique de l'invention, le procédé comporte une étape f) consistant à former des première et seconde couches d'oxyde transparent conducteur, respectivement sur les première et seconde couches de polysilicium ; l'étape f) étant exécutée après l'étape e).

Ainsi, un avantage procuré par les couches d'oxyde transparent conducteur est notamment d'assurer le contact électrique entre une électrode (par exemple métallique) et le substrat. Les couches d'oxyde transparent conducteur, avec une épaisseur adaptée, peuvent également assurer un rôle de couche antireflet. La couche antireflet permet de réduire les pertes optiques liées aux réflexions du rayonnement lumineux, et donc d'optimiser l'absorption du rayonnement lumineux par le substrat.

Selon une caractéristique de l'invention, le procédé comporte une étape g) consistant à former des électrodes sur les première et seconde couches d'oxyde transparent conducteur.

Selon une caractéristique de l'invention :
- l'étape a) est exécutée de sorte que les dopants de type n sont des atomes de phosphore et les dopants de type p sont des atomes de bore ;
- l'étape b) est exécutée de sorte que la température de recuit est comprise entre 700°C et 900°C.

Selon une caractéristique de l'invention, l'étape b) est exécutée de sorte que la température de recuit est comprise entre 700°C et 900°C.

### Définitions

- Par « substrat », on entend un support physique, autoporté, destiné à la fabrication d'une cellule photovoltaïque. Le substrat peut être une tranche (« *wafer»* en langue anglaise) découpée dans un lingot de silicium cristallin.
- Par « à base de », on entend que le silicium cristallin est le matériau principal et majoritaire composant le substrat.
- Par « silicium cristallin », on entend la forme multicristalline ou la forme monocristalline du silicium, excluant donc le silicium amorphe.
- Par « oxyde tunnel », on entend un oxyde suffisamment fin pour autoriser la circulation d'un courant électrique en son sein par effet tunnel. Un oxyde tunnel peut également assurer un rôle de barrière de diffusion des dopants de type n et des dopants de type p dans le substrat.
- Le terme « polysilicium » désigne le silicium polycristallin, comme dans l'usage courant. Toutefois, ce terme désigne dans la demande également le silicium nanocristallin, ou encore le silicium microcristallin.
- Par « dopant de type n », on entend des espèces qui, introduites dans une matrice d'un matériau semi-conducteur à base de silicium cristallin, donnent un électron à la bande de conduction.
- Par « dopant de type p », on entend des espèces qui, introduites dans une matrice d'un matériau semi-conducteur à base de silicium cristallin, acceptent un électron de la bande de conduction.
- Par « budget thermique », on entend un apport d'énergie de nature thermique, déterminé par le choix d'une valeur de la température de recuit et le choix d'une valeur de la durée du recuit.
- Par « agent oxydant », on entend une substance, de préférence sous forme gazeuse, capable d'oxyder la surface d'une couche de polysilicium par un transfert d'atomes.
- Par « activer électriquement », on entend un apport d'énergie de nature thermique pour provoquer la migration des dopants en sites substitutionnels dans lesquels ils seront susceptibles d'engendrer des porteurs.
- Par « prédéterminée », on entend que la première épaisseur est déterminée préalablement à la mise en œuvre d'un procédé selon l'invention.
- Par « épaisseur », on entend une dimension selon la normale à la première surface (ou à la seconde surface) du substrat.
- Par « oxyde transparent conducteur » (TCO pour « *Transparent Conductive Oxide* » en langue anglaise), on entend un oxyde transparent dans tout ou partie du spectre solaire, et électriquement conducteur. Par exemple, l'oxyde transparent conducteur peut présenter une transmittance supérieure ou égale à 60% (de préférence supérieure ou égale à 80%) sur le spectre [300 nm, 1200 nm].
- Les valeurs X et Y exprimées à l'aide des expressions « entre X et Y » ou « compris entre X et Y » sont incluses dans la plage de valeurs définie.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 (1a à 1f) comporte des vues schématiques en coupe, illustrant des étapes d'un premier mode de mise en œuvre d'un procédé selon l'invention.
Figure 2 (2a à 2f) comporte des vues schématiques en coupe, illustrant des étapes d'un deuxième mode de mise en œuvre d'un procédé selon l'invention.
Figure 3 est un graphique représentant l'évolution de la température (en ordonnées, unité arbitraire) à laquelle est exécutée l'étape b) en fonction du temps d'exécution (en abscisses, unité arbitraire) de l'étape b).

Il est à noter que les dessins décrits ci-avant sont schématiques, et ne sont pas nécessairement à l'échelle par souci de lisibilité et pour en simplifier leur compréhension. Les coupes sont effectuées selon la normale à la première surface (ou à la seconde surface) du substrat.

### Exposé détaillé des modes de réalisation

Les éléments identiques ou assurant la même fonction porteront les mêmes références pour les différents modes de réalisation, par souci de simplification. Les première et seconde couche de polysilicium porteront respectivement les références « 3a » et « 3b » avant le premier instant. Les première et seconde couche de polysilicium porteront respectivement les références « 3'a » et « 3'b » après avoir subi une consommation de matière entre les premier et second instants.

### Cas n°1 : les couches de polysilicium ont subi un dopage ex-situ

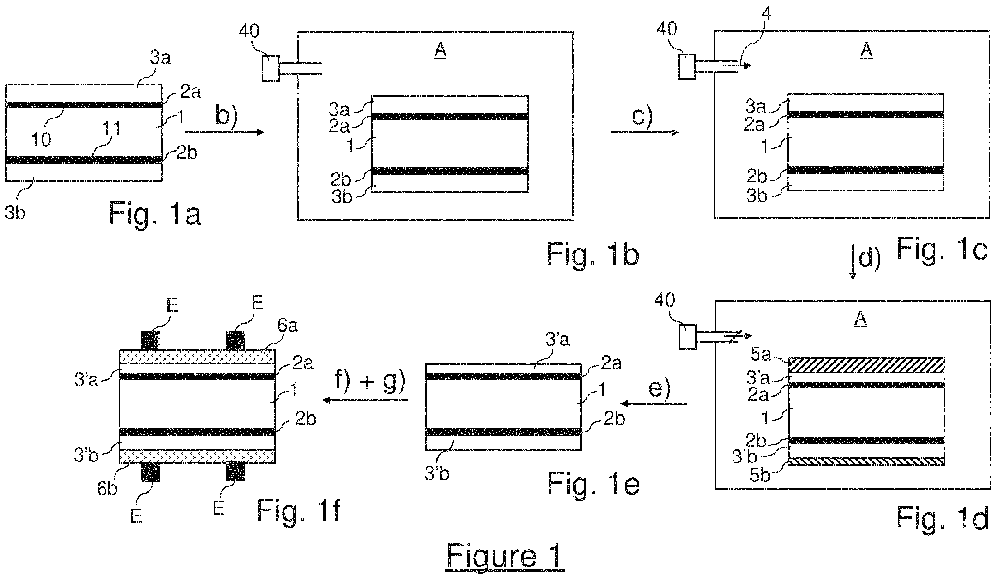

Comme illustré à la figure 1, un objet de l'invention est un procédé de fabrication d'une cellule photovoltaïque, comportant les étapes :
a) prévoir une structure comportant :
   - un substrat 1 à base de silicium cristallin, présentant des première et seconde surfaces 10, 11 opposées ;
   - des premier et second films d'oxyde 2a, 2b, de préférence de type oxyde tunnel, formés respectivement sur les première et seconde surfaces 10, 11 du substrat 1 ;
   - des première et seconde couches de polysilicium 3a, 3b, formées respectivement sur les premier et second films d'oxyde 2a, 2b, et comprenant respectivement des dopants de type n et des dopants de type p présentant respectivement des première et seconde concentrations surfaciques ; les dopants de type n étant de préférence des atomes de phosphore, les dopants de type p étant de préférence des atomes de bore ; les première et seconde couches de polysilicium 3a, 3b présentant chacune une épaisseur supérieure ou égale à 15 nm, de préférence supérieure ou égale à 20 nm ; l'étape a) est illustrée à la figure 1a ;
b) appliquer un recuit thermique à la structure, sous une atmosphère A, à une température de recuit T_{A} supérieure à une température minimale Tₘᵢₙ au-delà de laquelle les dopants de type n et les dopants de type p peuvent être électriquement activés ; l'étape b) est illustrée à la figure 1b ;
c) démarrer une injection d'un agent oxydant 4 dans l'atmosphère A au cours de l'étape b), de manière à former des première et seconde couches d'oxyde 5a, 5b, respectivement sur les première et seconde couches de polysilicium 3a, 3b ; l'injection étant démarrée à un premier instant t₁ définissant, avec la température de recuit T_{A}, un premier budget thermique adapté pour activer électriquement les dopants de type n et les dopants de type p ; l'étape c) est illustrée à la figure 1c ;
d) arrêter l'injection de l'agent oxydant 4 à un second instant t₂ définissant, avec la température de recuit T_{A}, un second budget thermique adapté à la première concentration surfacique de sorte que :
   - les première et seconde couches d'oxyde 5a, 5b, formées entre les premier et second instants t₁, t₂, présentent respectivement des première et seconde épaisseurs, la première épaisseur étant prédéterminée ;
   - la formation des première et seconde couches d'oxyde 5a, 5b, selon les première et seconde épaisseurs, consomme une quantité de polysilicium entre les premier et second instants t₁, t₂, adaptée pour que la première couche de polysilicium 3'a présente une épaisseur strictement inférieure à 15 nm à l'issue de l'étape d) ; la situation à l'issue de l'étape d) est illustrée à la figure 1d.

### Etape a)

Le substrat 1 de la structure prévue lors de l'étape a) est avantageusement dopé de type n. La première surface 10 du substrat 1 est destinée à être exposée à un rayonnement lumineux.

L'étape a) est avantageusement exécutée de sorte que les première et seconde surfaces 10, 11 du substrat 1 sont texturées afin de réduire le coefficient de réflexion et les pertes optiques dans la cellule photovoltaïque. Les première et seconde surfaces 10, 11 du substrat 1 comportent préférentiellement des motifs en pyramide inversée, agencés pour créer une rugosité de surface. La texturation est préférentiellement exécutée par une attaque chimique à base d'hydroxyde de potassium KOH.

À titre d'exemple non limitatif, le substrat 1 peut présenter une épaisseur de l'ordre de 150 µm.

L'étape a) est avantageusement exécutée de sorte que les premier et second films d'oxyde 2a, 2b sont de type oxyde tunnel. L'étape a) est avantageusement exécutée de sorte que les premier et second films d'oxyde 2a, 2b tunnel présentent une épaisseur inférieure ou égale à 3 nm, de préférence inférieure ou égale à 2 nm.

Les premier et second films d'oxyde 2a, 2b sont avantageusement des oxydes de silicium. Par « oxyde de silicium », on entend l'oxyde de silicium de formule SiO₂ (dioxyde de silicium) ou ses dérivés SiOₓ non-stœchiométriques.

L'étape a) peut comporter les étapes suivantes :
a₁) prévoir une structure comportant :
   - un substrat 1 à base de silicium cristallin, présentant des première et seconde surfaces 10, 11 opposées ;
   - des premier et second films d'oxyde 2a, 2b, de préférence de type oxyde tunnel, formés respectivement sur les première et seconde surfaces 10, 11 du substrat 1 ;
a₂) former des première et seconde couches de polysilicium 3a, 3b, respectivement sur les premier et second films d'oxyde 2a, 2b ;
a₃) implanter les dopants de type n et les dopants de type p, respectivement dans les première et seconde couches de polysilicium 3a, 3b.

L'étape a₂) est avantageusement exécutée par un dépôt chimique en phase vapeur à basse pression LPCVD.

L'étape a₃) est avantageusement exécutée par une technique d'implantation ionique par immersion plasma. Lorsque les dopants de type n sont des atomes de phosphore, l'implantation des atomes de phosphore est préférentiellement exécutée sous une atmosphère comportant de la phosphine PH₃. Lorsque les dopants de type p sont des atomes de bore, l'implantation des atomes de bore est préférentiellement exécutée sous une atmosphère comportant du diborane B₂H₆ ou du trifluorure de bore BF₃. L'étape a₃) est avantageusement exécutée de sorte que les atomes de phosphore et les atomes de bore présentent une densité volumique supérieure à 10²⁰ at./cm³. Ainsi, un avantage procuré est de créer un fort effet de champ propice à une bonne passivation des première et seconde surfaces 10, 11 du substrat 1, ainsi que de former une zone de contact électrique de bonne qualité.

D'autres techniques de formation de dopants dans les première et seconde couches de polysilicium 3a, 3b sont possibles : implantation par faisceau d'ions, utilisation d'un procédé sol-gel etc.

### Etape b)

A titre d'exemple non limitatif, l'étape a) peut être exécutée de sorte que les dopants de type n sont des atomes de phosphore, et les dopants de type p sont des atomes de bore. L'étape b) peut alors être exécutée de sorte que la température de recuit T_{A} est comprise entre 700°C et 900°C. Une telle température de recuit T_{A} permet d'activer électriquement les atomes de phosphore et les atomes de bore de façon concomitante. L'activation électrique des atomes de phosphore et des atomes de bore peut se produire dans le polysilicium à partir de 700°C. Une température de recuit T_{A} supérieure à 900°C risque de favoriser une trop grande diffusion des atomes de phosphore et des atomes de bore dans le substrat 1, à travers respectivement les première et seconde couches de polysilicium 3a, 3b, pouvant nuire aux propriétés des contacts passivés.

### Cas n°2 : les couches de polysilicium ont subi un dopage in-situ

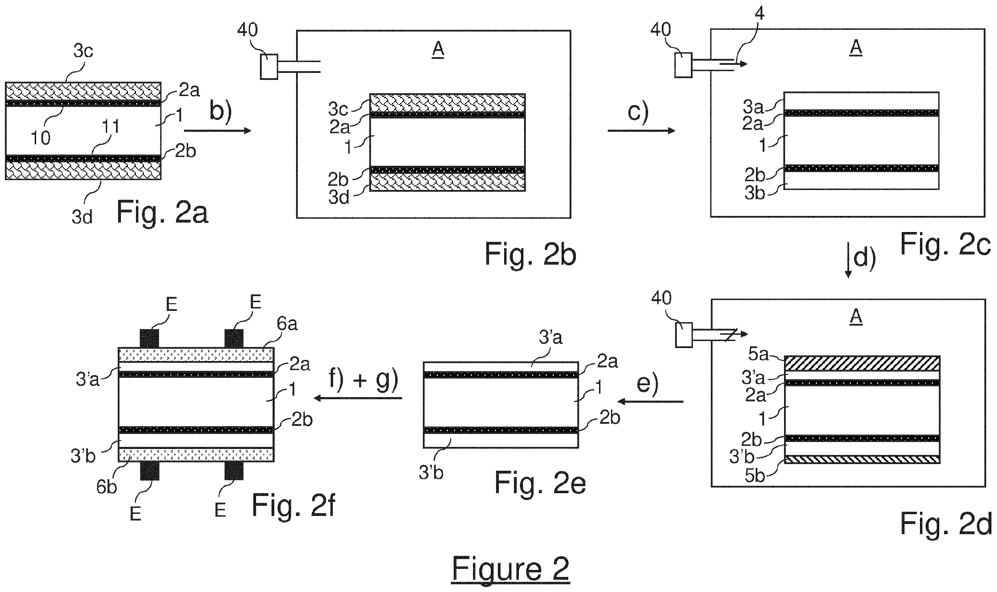

Comme illustré à la figure 2, un objet de l'invention est un procédé de fabrication d'une cellule photovoltaïque, comportant les étapes :
a') prévoir une structure comportant :
   - un substrat 1 à base de silicium cristallin, présentant des première et seconde surfaces 10, 11 opposées ;
   - des premier et second films d'oxyde 2a, 2b, de préférence de type oxyde tunnel, formés respectivement sur les première et seconde surfaces 10, 11 du substrat 1 ;
   - des première et seconde couches de silicium amorphe 3c, 3d, formées respectivement sur les premier et second films d'oxyde 2a, 2b, et comprenant respectivement des dopants de type n et des dopants de type p présentant respectivement des première et seconde concentrations surfaciques ; les dopants de type n étant de préférence des atomes de phosphore, les dopants de type p étant de préférence des atomes de bore ; les première et seconde couches de silicium amorphe 3c, 3d présentant chacune une épaisseur supérieure ou
   égale à 15 nm, de préférence supérieure ou égale à 20 nm ; l'étape a') est illustrée à la figure 2a ;
b) appliquer un recuit thermique à la structure, sous une atmosphère A, à une température de recuit T_{A} supérieure à une température minimale Tₘᵢₙ au-delà de laquelle les première et seconde couches de silicium amorphe 3c, 3d peuvent être cristallisées ; l'étape b) est illustrée à la figure 2b ;
c) démarrer une injection d'un agent oxydant 4 dans l'atmosphère A au cours de l'étape b), à un premier instant t₁ définissant, avec la température de recuit T_{A}, un premier budget thermique adapté pour cristalliser les première et seconde couches de silicium amorphe 3c, 3d de manière à former des première et seconde couches de polysilicium 3a, 3b ; l'étape c) étant exécutée de manière à former des première et seconde couches d'oxyde 5a, 5b, respectivement sur les première et seconde couches de polysilicium 3a, 3b ; l'étape c) est illustrée à la figure 2c ;
d) arrêter l'injection de l'agent oxydant 4 à un second instant t₂ définissant, avec la température de recuit T_{A}, un second budget thermique adapté à la première concentration surfacique de sorte que :
   - les première et seconde couches d'oxyde 5a, 5b, formées entre les premier et second instants t₁, t₂, présentent respectivement des première et seconde épaisseurs, la première épaisseur étant prédéterminée ;
   - la formation des première et seconde couches d'oxyde 5a, 5b, selon les première et seconde épaisseurs, consomme une quantité de polysilicium entre les premier et second instants t₁, t₂ adaptée pour que la première couche de polysilicium 3'a présente une épaisseur strictement inférieure à 15 nm à l'issue de l'étape d) ; la situation à l'issue de l'étape d) est illustrée à la figure 2d.

### Etape a')

Le substrat 1 de la structure prévue lors de l'étape a') est avantageusement dopé de type n. La première surface 10 du substrat 1 est destinée à être exposée à un rayonnement lumineux.

L'étape a') est avantageusement exécutée de sorte que les première et seconde surfaces 10, 11 du substrat 1 sont texturées afin de réduire le coefficient de réflexion et les pertes optiques dans la cellule photovoltaïque. Les première et seconde surfaces 10, 11 du substrat 1 comportent préférentiellement des motifs en pyramide inversée, agencés pour créer une rugosité de surface. La texturation est préférentiellement exécutée par une attaque chimique à base d'hydroxyde de potassium KOH.

À titre d'exemple non limitatif, le substrat 1 peut présenter une épaisseur de l'ordre de 150 µm.

L'étape a') est avantageusement exécutée de sorte que les premier et second films d'oxyde 2a, 2b sont de type oxyde tunnel. L'étape a') est avantageusement exécutée de sorte que les premier et second films d'oxyde 2a, 2b tunnel présentent une épaisseur inférieure ou égale à 3 nm, de préférence inférieure ou égale à 2 nm.

Les premier et second films d'oxyde 2a, 2b sont avantageusement des oxydes de silicium. Par « oxyde de silicium », on entend l'oxyde de silicium de formule SiO₂ (dioxyde de silicium) ou ses dérivés SiOₓ non-stœchiométriques.

L'étape a') peut comporter les étapes suivantes :
a'₁) prévoir une structure comportant :
   - un substrat 1 à base de silicium cristallin, présentant des première et seconde surfaces 10, 11 opposées ;
   - des premier et second films d'oxyde 2a, 2b, de préférence de type oxyde tunnel, formés respectivement sur les première et seconde surfaces 10, 11 du substrat 1 ;
a'₂) former des première et seconde couches de silicium amorphe 3c, 3d, respectivement sur les premier et second films d'oxyde 2a, 2b ;
a'₃) implanter les dopants de type n et les dopants de type p, respectivement dans les première et seconde couches de silicium amorphe 3a, 3b.

L'étape a'₂) est avantageusement exécutée par un dépôt chimique en phase vapeur assisté par plasma PECVD.

L'étape a'₃) peut être exécutée par une technique d'implantation ionique par immersion plasma. Lorsque les dopants de type n sont des atomes de phosphore, l'implantation des atomes de phosphore lors de l'étape a'₃) est préférentiellement exécutée sous une atmosphère comportant de la phosphine PH₃. Lorsque les dopants de type p sont des atomes de bore, l'implantation des atomes de bore lors de l'étape a'₃) est préférentiellement exécutée sous une atmosphère comportant du diborane B₂H₆ ou du trifluorure de bore BF₃. L'étape a'₃) est avantageusement exécutée de sorte que les atomes de phosphore et les atomes de bore présentent une densité volumique supérieure à 10²⁰ at./cm³. Ainsi, un avantage procuré est de créer un fort effet de champ propice à une bonne passivation des première et seconde surfaces 10, 11 du substrat 1, ainsi que de former une zone de contact électrique de bonne qualité.

D'autres techniques de formation de dopants dans les première et seconde couches de silicium amorphe 3c, 3d sont possibles : implantation par faisceau d'ions, utilisation d'un procédé sol-gel etc.

### Etape b)

A titre d'exemple non limitatif, l'étape b) peut être exécutée de sorte que la température de recuit T_{A} est comprise entre 700°C et 900°C. Une telle température de recuit T_{A} permet de cristalliser les première et seconde couches de silicium amorphe 3c, 3d. La cristallisation des première et seconde couches de silicium amorphe 3c, 3d s'accompagne de l'activation électrique des dopants de type n et des dopants de type p par diffusion.

### Caractéristiques communes aux objets de l'invention

### Etape b)

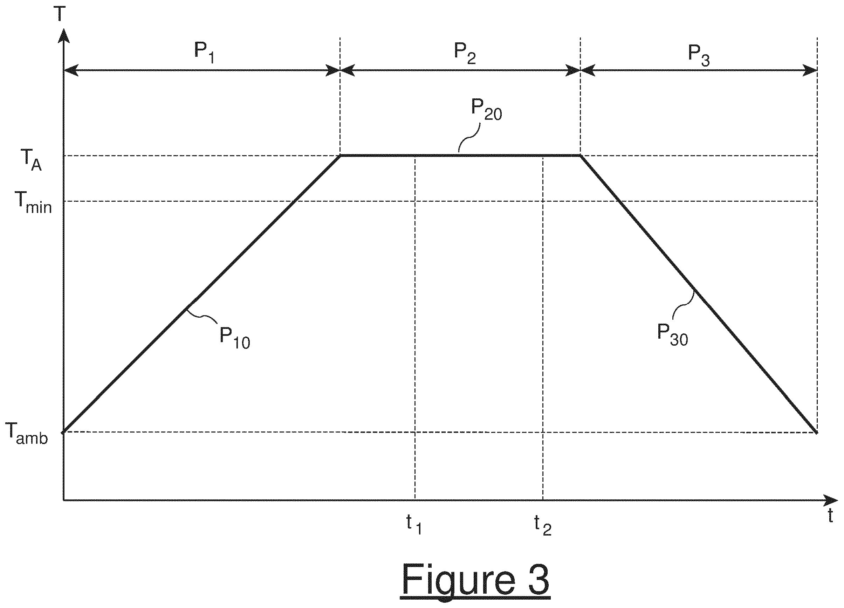

Comme illustré à la figure 3, le recuit thermique appliqué lors de l'étape b) comporte :
- une première phase P₁, comprenant une montée en température P₁₀ (par exemple selon une rampe de température de 1°C à 5°C par minute) jusqu'à atteindre la température de recuit T_{A} ;
- une deuxième phase P₂, comprenant un plateau de température P₂₀ égal à la température de recuit T_{A} ;
- une troisième phase en P₃, comprenant une descente en température P₃₀ à partir de la température de recuit T_{A}, jusqu'à atteindre une température ambiante T_{amb}.

L'atmosphère A sous laquelle est appliqué le recuit thermique lors de l'étape b) comporte avantageusement du diazote N₂ ou de l'argon Ar.

Le recuit thermique appliqué lors de l'étape b) est un recuit thermique global au sens où il est appliqué à l'ensemble de la structure. Il ne s'agit donc pas d'un recuit thermique localisé appliqué sur une partie de la structure, par exemple à l'aide d'un laser.

L'étape b) est préférentiellement exécutée dans un four muni de moyens d'injection 40 d'un agent oxydant 4.

### Etape c)

L'étape c) est avantageusement exécutée de sorte que l'injection de l'agent oxydant 4 est démarrée durant la deuxième phase P₂., après l'activation électrique des dopants de type n et des dopants de type p.

L'étape c) est avantageusement exécutée de sorte que l'agent oxydant 4 comporte du dioxygène O₂.

### Etape d)

Le second instant t₂ définit, avec la température de recuit T_{A}, un second budget thermique adapté à la première concentration surfacique de sorte que les première et seconde couches d'oxyde 5a, 5b, formées entre les premier et second instants t₁, t₂, présentent respectivement des première et seconde épaisseurs, la première épaisseur étant prédéterminée. Plus précisément, la première épaisseur est prédéterminée en fonction de l'épaisseur souhaitée de la première couche de polysilicium 3'a à l'issue de l'étape d) et donc de la consommation de la quantité de matière (polysilicium) correspondante. Le second budget thermique est adapté à la première concentration surfacique pour former la première couche d'oxyde 5a selon la première épaisseur prédéterminée. La seconde épaisseur dépend du second budget thermique (et donc de la première épaisseur prédéterminée) et de la seconde concentration surfacique.

L'étape d) est avantageusement exécutée de sorte que l'injection de l'agent oxydant 4 est arrêtée durant la deuxième phase P₂. À titre d'exemple non limitatif, la durée s'écoulant entre les premier et second instant t₁, t₂ peut être de l'ordre de quelques minutes.

Selon une alternative, l'étape d) peut être exécutée de sorte que l'injection de l'agent oxydant 4 est arrêtée durant la troisième phase P₃, dès lors que le second budget thermique est adapté pour obtenir la première épaisseur prédéterminée pour la première couche d'oxyde 5a, et par là-même l'épaisseur désirée pour la première couche de polysilicium 3'a.

L'étape d) est avantageusement exécutée de sorte que les première et seconde épaisseurs sont supérieures ou égales à 2 nm, de préférence comprise entre 5 nm et 30 nm. À titre d'exemple non limitatif, la première épaisseur prédéterminée peut être comprise entre 10 nm et 15 nm. À titre d'exemple non limitatif, la seconde épaisseur peut être comprise entre 3 nm et 5 nm. À titre d'exemple non limitatif, la première couche de polysilicium 3'a peut présenter une épaisseur de 6 nm (± 1 nm) à l'issue de l'étape d).

### Etape e)

Comme illustré aux figures 1e et 2e, le procédé comporte avantageusement une étape e) consistant à retirer les première et seconde couches d'oxyde 5a, 5b formées entre les premier et second instants t₁, t₂ ; l'étape e) étant exécutée après l'étape d), de préférence par une solution d'acide fluorhydrique HF, plus préférentiellement dilué. L'étape e) peut également être exécutée par des vapeurs d'acide fluorhydrique HF pour réduire les intrants chimiques. Selon une autre possibilité, l'étape e) peut être exécutée par une gravure plasma, de préférence avec un plasma fluoré pour réduire les intrants chimiques.

### Etape f)

Comme illustré aux figures 1f et 2f, le procédé comporte avantageusement une étape f) consistant à former des première et seconde couches d'oxyde transparent conducteur 6a, 6b, respectivement sur les première et seconde couches de polysilicium 3'a, 3'b. L'étape f) est exécutée après l'étape e).

Les première et seconde couches d'oxyde transparent conducteur 6a, 6b sont avantageusement réalisées dans un matériau choisi parmi CuO, NiO, TiO, un oxyde de fluor dopé à l'étain, l'oxyde d'étain SnO₂, l'oxyde de zinc ZnO ; SnO₂ et ZnO étant de préférence respectivement dopé au fluor et à l'aluminium.

### Etape g)

Comme illustré aux figures 1f et 2f, le procédé comporte avantageusement une étape g) consistant à former des électrodes E sur les première et seconde couches d'oxyde transparent conducteur 6a, 6b. Plus précisément, l'étape g) peut consister à former au moins une électrode E sur la première couche d'oxyde transparent conducteur 6a, et au moins une électrode E sur la seconde couche d'oxyde transparent conducteur 6b. L'étape g) comporte avantageusement une étape de métallisation, de préférence exécutée par sérigraphie. Chaque électrode E est préférentiellement réalisée en argent et/ou aluminium.

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'une cellule photovoltaïque, comportant les étapes :
a) prévoir une structure comportant :
- un substrat (1) à base de silicium cristallin, présentant des première et seconde surfaces (10, 11) opposées ;
- des premier et second films d'oxyde (2a, 2b), de préférence de type oxyde tunnel, formés respectivement sur les première et seconde surfaces (10, 11) du substrat (1) ;
- des première et seconde couches de polysilicium (3a, 3b), formées respectivement sur les premier et second films d'oxyde (2a, 2b), et comprenant respectivement des dopants de type n et des dopants de type p présentant respectivement des première et seconde concentrations surfaciques ; les dopants de type n étant de préférence des atomes de phosphore, les dopants de type p étant de préférence des atomes de bore ; les première et seconde couches de polysilicium (3a, 3b) présentant chacune une épaisseur supérieure ou égale à 15 nm, de préférence supérieure ou égale à 20 nm ;
b) appliquer un recuit thermique à la structure, sous une atmosphère (A), à une température de recuit (T_{A}) supérieure à une température minimale (Tₘᵢₙ) au-delà de laquelle les dopants de type n et les dopants de type p peuvent être électriquement activés ;
c) démarrer une injection d'un agent oxydant (4) dans l'atmosphère (A) au cours de l'étape b), de manière à former des première et seconde couches d'oxyde (5a, 5b), respectivement sur les première et seconde couches de polysilicium (3a, 3b) ; l'injection étant démarrée à un premier instant (t₁) définissant, avec la température de recuit (T_{A}), un premier budget thermique adapté pour activer électriquement les dopants de type n et les dopants de type p ;
d) arrêter l'injection de l'agent oxydant (4) à un second instant (t₂) définissant, avec la température de recuit (T_{A}), un second budget thermique adapté à la première concentration surfacique de sorte que :
- les première et seconde couches d'oxyde (5a, 5b), formées entre les premier et second instants (t₁, t₂), présentent respectivement des première et seconde épaisseurs ; la première épaisseur étant prédéterminée ;
- la formation des première et seconde couches d'oxyde (5a, 5b), selon les première et seconde épaisseurs, consomme une quantité de polysilicium entre les premier et second instants (t₁, t₂) adaptée pour que la première couche de polysilicium (3'a) présente une épaisseur strictement inférieure à 15 nm à l'issue de l'étape d).

2. Procédé de fabrication d'une cellule photovoltaïque, comportant les étapes :
a') prévoir une structure comportant :
- un substrat (1) à base de silicium cristallin, présentant des première et seconde surfaces (10, 11) opposées ;
- des premier et second films d'oxyde (2a, 2b), de préférence de type oxyde tunnel, formés respectivement sur les première et seconde surfaces (10, 11) du substrat (1) ;
- des première et seconde couches de silicium amorphe (3c, 3d), formées respectivement sur les premier et second films d'oxyde (2a, 2b), et comprenant respectivement des dopants de type n et des dopants de type p présentant respectivement des première et seconde concentrations surfaciques ; les dopants de type n étant de préférence des atomes de phosphore, les dopants de type p étant de préférence des atomes de bore ; les première et seconde couches de silicium amorphe (3c, 3d) présentant chacune une épaisseur supérieure ou égale à 15 nm, de préférence supérieure ou égale à 20 nm ;
b) appliquer un recuit thermique à la structure, sous une atmosphère (A), à une température de recuit (T_{A}) supérieure à une température minimale (Tₘᵢₙ) au-delà de laquelle les première et seconde couches de silicium amorphe (3c, 3d) peuvent être cristallisées ;
c) démarrer une injection d'un agent oxydant (4) dans l'atmosphère (A) au cours de l'étape b), à un premier instant (t₁) définissant, avec la température de recuit (T_{A}), un premier budget thermique adapté pour cristalliser les première et seconde couches de silicium amorphe (3c, 3d) de manière à former des première et seconde couches de polysilicium (3a, 3b) ; l'étape c) étant exécutée de manière à former des première et seconde couches d'oxyde (5a, 5b), respectivement sur les première et seconde couches de polysilicium (3a, 3b) ;
d) arrêter l'injection de l'agent oxydant (4) à un second instant (t₂) définissant, avec la température de recuit (T_{A}), un second budget thermique adapté à la première concentration surfacique de sorte que :
- les première et seconde couches d'oxyde (5a, 5b), formées entre les premier et second instants (t₁, t₂), présentent respectivement des première et seconde épaisseurs ; la première épaisseur étant prédéterminée ;
- la formation des première et seconde couches d'oxyde (5a, 5b), selon les première et seconde épaisseurs, consomme une quantité de polysilicium entre les premier et second instants (t₁, t₂) adaptée pour que la première couche de polysilicium (3'a) présente une épaisseur strictement inférieure à 15 nm à l'issue de l'étape d).

3. Procédé selon la revendication 1 ou 2, dans lequel le recuit thermique appliqué lors de l'étape b) comporte :
- une première phase (P₁), comprenant une montée en température (P₁₀) jusqu'à atteindre la température de recuit (T_{A}) ;
- une deuxième phase (P₂), comprenant un plateau de température (P₂₀) égal à la température de recuit (T_{A}) ;
- une troisième phase (P₃), comprenant une descente en température (P₃₀) à partir de la température de recuit (T_{A}) ;
dans lequel l'étape c) est exécutée de sorte que l'injection de l'agent oxydant (4) est démarrée durant la deuxième phase (P₂), et l'étape d) est exécutée de sorte que l'injection de l'agent oxydant (4) est arrêtée durant la deuxième phase (P₂).

4. Procédé selon l'une des revendications 1 à 3, dans lequel l'étape c) est exécutée de sorte que l'agent oxydant (4) comporte du dioxygène O₂.

5. Procédé selon l'une des revendications 1 à 4, dans lequel l'atmosphère (A) sous laquelle est appliqué le recuit thermique lors de l'étape b) comporte du diazote N₂ ou de l'argon Ar.

6. Procédé selon l'une des revendications 1 à 5, dans lequel l'étape d) est exécutée de sorte que les première et seconde épaisseurs sont supérieures ou égales à 2 nm.

7. Procédé selon l'une des revendications 1 à 6, comportant une étape e) consistant à retirer les première et seconde couches d'oxyde (5a, 5b) formées entre les premier et second instants (t₁, t₂) ; l'étape e) étant exécutée après l'étape d), de préférence par une solution d'acide fluorhydrique HF.

8. Procédé selon la revendication 7, comportant une étape f) consistant à former des première et seconde couches d'oxyde transparent conducteur (6a, 6b), respectivement sur les première et seconde couches de polysilicium (3'a, 3'b) ; l'étape f) étant exécutée après l'étape e).

9. Procédé selon la revendication 8, comportant une étape g) consistant à former des électrodes (E) sur les première et seconde couches d'oxyde transparent conducteur (6a, 6b).

10. Procédé selon la revendication 1 et l'une des revendications 3 à 9 en combinaison avec la revendication 1, dans lequel :
- l'étape a) est exécutée de sorte que les dopants de type n sont des atomes de phosphore et les dopants de type p sont des atomes de bore ;
- l'étape b) est exécutée de sorte que la température de recuit (T_{A}) est comprise entre 700°C et 900°C.

11. Procédé selon la revendication 2 et l'une des revendications 3 à 9 en combinaison avec la revendication 2, dans lequel l'étape b) est exécutée de sorte que la température de recuit (T_{A}) est comprise entre 700°C et 900°C.

## Patentansprüche

1. Verfahren zur Herstellung einer Photovoltaikzelle, umfassend die Schritte:
a) Bereitstellen einer Struktur, umfassend:
- ein Substrat (1) auf Basis von kristallinem Silicium, das entgegengesetzte erste und zweite Oberflächen (10, 11) aufweist;
- erste und zweite Oxidfilme (2a, 2b), bevorzugt vom Typ Tunneloxid, die auf den ersten beziehungsweise zweiten Oberflächen (10, 11) des Substrats (1) gebildet sind;
- erste und zweite Polysiliciumschichten (3a, 3b), die auf den ersten beziehungsweise zweiten Oxidfilmen (2a, 2b) gebildet sind und n-Typ-Dotierungsstoffe beziehungsweise p-Typ-Dotierungsstoffe umfassen, die erste beziehungsweise zweite flächenbezogene Konzentrationen aufweisen; wobei die n-Typ-Dotierungsstoffe bevorzugt Phosphoratome sind, wobei die p-Typ-Dotierungsstoffe bevorzugt Boratome sind; wobei die ersten und zweiten Polysiliciumschichten (3a, 3b) jeweils eine Dicke größer als oder gleich 15 nm, bevorzugt größer oder gleich 20 nm aufweisen;
b) Anwenden eines thermischen Glühens auf die Struktur, unter einer Atmosphäre (A), bei einer Glühtemperatur (T_{A}) über einer minimalen Temperatur (Tₘᵢₙ), über der die n-Typ-Dotierungsstoffe und die p-Typ-Dotierungsstoffe elektrisch aktiviert werden können;
c) Starten einer Einleitung eines Oxidationsmittels (4) in die Atmosphäre (A) während des Schritts b), so dass erste und zweite Oxidschichten (5a, 5b) auf den ersten beziehungsweise zweiten Polysiliciumschichten (3a, 3b) gebildet werden; wobei die Einleitung zu einem ersten Zeitpunkt (t₁) gestartet wird, der mit der Glühtemperatur (T_{A}) ein erstes thermisches Budget definiert, das geeignet ist, die n-Typ-Dotierungsstoffe und die p-Typ-Dotierungsstoffe elektrisch zu aktivieren;
d) Stoppen der Einleitung des Oxidationsmittels (4) zu einem zweiten Zeitpunkt (t₂), der mit der Glühtemperatur (T_{A}) ein zweites thermisches Budget definiert, das an die erste flächenbezogene Konzentration angepasst ist, so dass:
- die ersten und zweiten Oxidschichten (5a, 5b), die zwischen den ersten und zweiten Zeitpunkten (t₁, t₂) gebildet werden, erste beziehungsweise zweite Dicken aufweisen; wobei die erste Dicke vorbestimmt ist;
- das Bilden der ersten und zweiten Oxidschichten (5a, 5b) gemäß den ersten und zweiten Dicken eine Polysiliciummenge zwischen den ersten und zweiten Zeitpunkten (t₁, t₂) verbraucht, die so angepasst ist, dass die erste Polysiliciumschicht (3'a) am Ende des Schritts d) eine Dicke strikt kleiner als 15 nm aufweist.

2. Verfahren zur Herstellung einer Photovoltaikzelle, umfassend die Schritte:
a') Bereitstellen einer Struktur, umfassend:
- ein Substrat (1) auf Basis von kristallinem Silicium, das entgegengesetzte erste und zweite Oberflächen (10, 11) aufweist;
- erste und zweite Oxidfilme (2a, 2b), bevorzugt vom Typ Tunneloxid, die auf den ersten beziehungsweise zweiten Oberflächen (10, 11) des Substrats (1) gebildet sind;
- erste und zweite Schichten aus amorphem Silicium (3c, 3d), die auf den ersten beziehungsweise zweiten Oxidfilmen (2a, 2b) gebildet sind und n-Typ-Dotierungsstoffe beziehungsweise p-Typ-Dotierungsstoffe umfassen, die erste beziehungsweise zweite flächenbezogene Konzentrationen aufweisen; wobei die n-Typ-Dotierungsstoffe bevorzugt Phosphoratome sind, wobei die p-Typ-Dotierungsstoffe bevorzugt Boratome sind; wobei die ersten und zweiten Schichten aus amorphem Silicium (3c, 3d) jeweils eine Dicke größer als oder gleich 15 nm, bevorzugt größer oder gleich 20 nm aufweisen;
b) Anwenden eines thermischen Glühens auf die Struktur, unter einer Atmosphäre (A), bei einer Glühtemperatur (T_{A}) über einer minimalen Temperatur (Tₘᵢₙ), über der die ersten und zweiten Schichten aus amorphem Silicium (3c, 3d) kristallisiert werden können;
c) Starten einer Einleitung eines Oxidationsmittels (4) in die Atmosphäre (A) während des Schritts b) zu einem ersten Zeitpunkt (t₁), der mit der Glühtemperatur T_{A}) ein erstes thermisches Budget definiert, das dazu angepasst ist, die ersten und zweiten Schichten aus amorphem Silicium (3c, 3d) zu kristallisieren, so dass erste und zweite Polysiliciumschichten (3a, 3b) gebildet werden; wobei der Schritt c) so ausgeführt wird, dass erste und zweite Oxidschichten (5a, 5b) auf den ersten beziehungsweise zweiten Polysiliciumschichten (3a, 3b) gebildet werden;
d) Stoppen der Einleitung des Oxidationsmittels (4) zu einem zweiten Zeitpunkt (t₂), der mit der Glühtemperatur (T_{A}) ein zweites thermisches Budget definiert, das an die erste flächenbezogene Konzentration angepasst ist, so dass:
- die ersten und zweiten Oxidschichten (5a, 5b), die zwischen den ersten und zweiten Zeitpunkten (t₁, t₂) gebildet werden, erste beziehungsweise zweite Dicken aufweisen; wobei die erste Dicke vorbestimmt ist;
- das Bilden der ersten und zweiten Oxidschichten (5a, 5b) gemäß den ersten und zweiten Dicken eine Polysiliciummenge zwischen den ersten und zweiten Zeitpunkten (t₁, t₂) verbraucht, die so angepasst ist, dass die erste Polysiliciumschicht (3'a) am Ende des Schritts d) eine Dicke strikt kleiner als 15 nm aufweist.

3. Verfahren nach Anspruch 1 oder 2, wobei das beim Schritt b) angewandte thermische Glühen umfasst:
- eine erste Phase (P₁), die einen Temperaturanstieg (P₁₀) bis zum Erreichen der Glühtemperatur (T_{A}) umfasst;
- eine zweite Phase (P₂), die ein Temperaturplateau (P₂₀) gleich der Glühtemperatur (T_{A}) umfasst;
- eine dritte Phase (P₃), die eine Temperaturabsenkung (P₃₀) ausgehend von der Glühtemperatur (T_{A}) umfasst;
wobei der Schritt c) so ausgeführt wird, dass die Einleitung des Oxidationsmittels (4) während der zweiten Phase (P₂) gestartet wird, und der Schritt d) so ausgeführt wird, dass die Einleitung des Oxidationsmittels (4) während der zweiten Phase (P₂) gestoppt wird.

4. Verfahren nach einem der Ansprüche 1 bis 3, wobei der Schritt c) so ausgeführt wird, dass das Oxidationsmittel (4) Disauerstoff O₂ umfasst.

5. Verfahren nach einem der Ansprüche 1 bis 4, wobei die Atmosphäre (A), unter der das thermische Glühen beim Schritt b) angewandt wird, Distickstoff N₂ oder Argon Ar umfasst.

6. Verfahren nach einem der Ansprüche 1 bis 5, wobei der Schritt d) so ausgeführt wird, dass die ersten und zweiten Dicken grösser als oder gleich 2 nm sind.

7. Verfahren nach einem der Ansprüche 1 bis 6, umfassend einen Schritt e), der darin besteht, die ersten und zweiten Oxidschichten (5a, 5b), die zwischen den ersten und zweiten Zeitpunkten (t₁, t₂) gebildet werden, zu entfernen; wobei der Schritt e) nach dem Schritt d) ausgeführt wird, bevorzugt durch eine Lösung aus Flusssäure HF.

8. Verfahren nach Anspruch 7, umfassend einen Schritt f), der darin besteht, erste und zweite Schichten aus leitfähigem transparentem Oxid (6a, 6b) auf den ersten beziehungsweise zweiten Polysiliciumschichten (3'a, 3'b) zu bilden, wobei der Schritt f) nach dem Schritt e) ausgeführt wird.

9. Verfahren nach Anspruch 8, umfassend einen Schritt g), der darin besteht, Elektroden (E) auf den ersten und zweiten Schichten aus leitfähigem transparentem Oxid (6a, 6b) zu bilden.

10. Verfahren nach Anspruch 1 und einem der Ansprüche 3 bis 9 in Kombination mit Anspruch 1, wobei:
- der Schritt a) so ausgeführt wird, dass die n-Typ-Dotierungsstoffe Phosphoratome sind und die p-Typ-Dotierungsstoffe Boratome sind;
- der Schritt b) so ausgeführt wird, dass die Glühtemperatur (T_{A}) zwischen 700 °C und 900 °C liegt.

11. Verfahren nach Anspruch 2 und einem der Ansprüche 3 bis 9 in Kombination mit Anspruch 2, wobei der Schritt b) so ausgeführt wird, dass die Glühtemperatur (T_{A}) zwischen 700 °C und 900 °C liegt.

## Claims

1. Process for manufacturing a photovoltaic cell, comprising the following steps:
a) providing a structure comprising:
- a crystalline silicon-based substrate (1) having opposite first and second surfaces (10, 11);
- first and second oxide films (2a, 2b), preferably of tunnel-oxide type, formed on the first and second surfaces (10, 11) of the substrate (1), respectively;
- first and second polysilicon layers (3a, 3b) that are formed on the first and second oxide films (2a, 2b), respectively, and that comprise n-type dopants and p-type dopants, respectively, having first and second concentrations per unit area, respectively, the n-type dopants preferably being phosphorus atoms and the p-type dopants preferably being boron atoms, the first and second polysilicon layers (3a, 3b) each having a thickness greater than or equal to 15 nm and preferably greater than or equal to 20 nm;
b) applying, under an atmosphere (A), a thermal anneal to the structure at an annealing temperature (T_{A}) greater than a minimum temperature (Tₘᵢₙ) of electrical activation of the n-type dopants and p-type dopants;
c) initiating an injection of an oxidant (4) into the atmosphere (A) in step b), so as to form first and second oxide layers (5a, 5b) on the first and second polysilicon layers (3a, 3b), respectively, the injection being initiated at a first time (t₁) defining, with the annealing temperature (T_{A}), a first thermal budget configured to electrically activate the n-type dopants and p-type dopants;
d) stopping the injection of the oxidant (4) at a second time (t₂) defining, with the annealing temperature (T_{A}), a second thermal budget configured for the first concentration per unit area, in such a way that:
- the first and second oxide layers (5a, 5b) formed between the first and second times (t₁, t₂) have first and second thicknesses, respectively, the first thickness being predetermined;
- the formation of the first and second oxide layers (5a, 5b), with the first and second thicknesses, consumes an amount of polysilicon between the first and second times (t₁, t₂) that is configured so that the first polysilicon layer (3'a) has a thickness strictly less than 15 nm at the end of step d).

2. Process for manufacturing a photovoltaic cell, comprising the following steps:
a') providing a structure comprising:
- a crystalline silicon-based substrate (1) having opposite first and second surfaces (10, 11);
- first and second oxide films (2a, 2b), preferably of tunnel-oxide type, formed on the first and second surfaces (10, 11) of the substrate (1), respectively;
- first and second amorphous-silicon layers (3c, 3d) that are formed on the first and second oxide films (2a, 2b), respectively, and that comprise n-type dopants and p-type dopants, respectively, having first and second concentrations per unit area, respectively, the n-type dopants preferably being phosphorus atoms and the p-type dopants preferably being boron atoms, the first and second amorphous-silicon layers (3c, 3d) each having a thickness greater than or equal to 15 nm and preferably greater than or equal to 20 nm;
b) applying, under an atmosphere (A), a thermal anneal to the structure at an annealing temperature (T_{A}) greater than a minimum temperature (Tₘᵢₙ) of crystallization of the first and second amorphous-silicon layers (3c, 3d);
c) initiating an injection of an oxidant (4) into the atmosphere (A) in step b), at a first time (t₁) defining, with the annealing temperature (T_{A}), a first thermal budget configured to crystallize the first and second amorphous-silicon layers (3c, 3d) so as to form first and second polysilicon layers (3a, 3b), step c) being executed so as to form first and second oxide layers (5a, 5b) on the first and second polysilicon layers (3a, 3b), respectively;
d) stopping the injection of the oxidant (4) at a second time (t₂) defining, with the annealing temperature (T_{A}), a second thermal budget configured for the first concentration per unit area, in such a way that:
- the first and second oxide layers (5a, 5b) formed between the first and second times (t₁, t₂) have first and second thicknesses, respectively, the first thickness being predetermined;
- the formation of the first and second oxide layers (5a, 5b), with the first and second thicknesses, consumes an amount of polysilicon between the first and second times (t₁, t₂) that is configured so that the first polysilicon layer (3'a) has a thickness strictly less than 15 nm at the end of step d).

3. Process according to Claim 1 or 2, wherein the thermal anneal applied in step b) comprises:
- a first phase (P₁), comprising a temperature rise (P₁₀) until the annealing temperature (T_{A}) is reached;
- a second phase (P₂), comprising a temperature plateau (P₂₀) at a temperature equal to the annealing temperature (T_{A});
- a third phase (P₃), comprising a temperature drop (P₃₀) from the annealing temperature (T_{A});
and wherein step c) is executed in such a way that the injection of the oxidant (4) is initiated during the second phase (P₂), and step d) is executed in such a way that the injection of the oxidant (4) is stopped during the second phase (P₂).

4. Process according to any of Claims 1 to 3, wherein step c) is executed in such a way that the oxidant (4) contains dioxygen O₂.

5. Process according to any of Claims 1 to 4, wherein the atmosphere (A) under which the thermal anneal is applied in step b) contains dinitrogen N₂ or argon Ar.

6. Process according to any of Claims 1 to 5, wherein step d) is executed in such a way that the first and second thicknesses are greater than or equal to 2 nm.

7. Process according to any of Claims 1 to 6, comprising a step e) of removing the first and second oxide layers (5a, 5b) formed between the first and second times (t₁, t₂), step e) being executed after step d), preferably using a solution of hydrofluoric acid HF.

8. Process according to Claim 7, comprising a step f) of forming first and second transparent-conductive-oxide layers (6a, 6b) on the first and second polysilicon layers (3'a, 3'b), respectively, step f) being executed after step e).

9. Process according to Claim 8, comprising a step g) of forming electrodes (E) on the first and second transparent-conductive-oxide layers (6a, 6b).

10. Process according to Claim 1 and any of Claims 3 to 9 in combination with Claim 1, wherein:
- step a) is executed in such a way that the n-type dopants are phosphorus atoms and the p-type dopants are boron atoms;
- step b) is executed in such a way that the annealing temperature (T_{A}) is between 700°C and 900°C.

11. Process according to Claim 2 and any of Claims 3 to 9 in combination with Claim 2, wherein step b) is executed in such a way that the annealing temperature (T_{A}) is between 700°C and 900°C.
